# EUROPEAN PATENT SPECIFICATION

(11) **EP 1 341 616 B1**
(45) Date of publication and mention of the grant of the patent: **15.06.2005**
(21) Application number: 01999437.5
(22) Date of filing: 06.12.2001
(51) Int. Cl.: B05D 1/02, H01L 51/40, B05D 5/12

(54) **PATTERNED DEPOSITION USING COMPRESSED CARBON DIOXIDE**
GEMUSTERTE BESCHICHTUNG MIT KOMPRIMIERTEM KOHLENDIOXID
DEPOT EN RELIEF AU MOYEN DE DIOXYDE DE CARBONE COMPRIME

(30) Priority: 06.12.2000 GB 0029673; 26.06.2001 GB 0115538
(43) Date of publication of application: 10.09.2003
(73) Proprietor: Holmes, Andrew Bruce, Cambridge CB2 2AL (GB); Al-Duri, Bushra, Edgbaston, Birmingham B15 2TT (GB); Gaspar, Filipe, Edgbaston, Birmingham B15 2TT (GB); Leeke, Gary, Edgbaston, Birmingham B15 2TT (GB); Lu, Tiejun, Edgbaston, Birmingham B15 2TT (GB); Santos, Regina, Edgbaston, Birmingham B15 2TT (GB); Seville, Jonathan, Edgbaston, Birmingham B15 2TT (GB); Huck, Wilhelm Theodorus Stefanus, Comberton, Cambridge CB3 7DS (GB); Luscombe, Christine Keiko, Cambridge CB5 8AW (GB)
(72) Inventor: HUCK, Wilhelm T S., Melville Lab for Polymer Synth, Cambridge CB2 3RA (GB); HOLMES, Andrew B, Melville Lab for Polymer Synthes, Cambridge CB2 3RA (GB); LUSCOMBE, Christine K, Melville Lab Polymer Synth, Cambridge CB2 3RA (GB); SEVILLE, Jonathan, Dept of Chemical Engineering, West Midlands, Birmingham B15 2TT (GB); SANTOS, Regina, c/o Dpt of Chemical Engineering, Edgbaston, BirminghamB15 2TT (GB); AL-DURI, Bushra, c/o Dpt of Chemical Engineering, Edgbaston, Birmingham B15 2TT (GB); GASPAR, Filipe, c/o Dpt of Chemical Engineering, Edgbaston, Birmingham B15 2TT (GB); LEEKE, Gary, c/oDepartment of Chemical Engineering, Edgbaston, Birmingham B15 2TT (GB); LU, Tiejun, c/o Department of Chemical Engineering, Edgbaston, Birmingham B15 2TT (GB)
(74) Representative: Andrews, Timothy Stephen
(86) International application number: PCT/GB2001/005402
(87) International publication number: WO 2002/045868

(56) References cited:
- EP-A- 0 473 424
- WO-A-01/47043
- WO-A-99/19081
- DE-A- 19 918 193
- US-A- 6 087 196
- HEBNER T R ET AL: "INK-JET PRINTING OF DOPED POLYMERS FOR ORGANIC LIGHT EMITTING DEVICES" APPLIED PHYSICS LETTERS, AMERICAN INSTITUTE OF PHYSICS. NEW YORK, US, vol. 72, no. 5, 2 February 1998 (1998-02-02), pages 519-521, XP000737411 ISSN: 0003-6951 cited in the application

## Description

### Field of the Invention

The present invention relates to a method for the patterned deposition of materials such as polymers and small organic molecules on surfaces, and to devices manufactured using this process.

### Background to the invention

Supercritical carbon dioxide has been used for polymer synthesis and polymer processing. This has been extensively reviewed in the past and the state of the art is summarised in an article by Cooper [A. I. Cooper, *J*. *Mater. Chem*., 2000, **10**, 207]. Compressed carbon dioxide is also used as a solvent for the preparation of organic molecules and this has been summarised in a special issue of *Chemical Reviews.* [see Special Issue: *Chem. Rev.* 1999, **99**, #2]. Unlike conventional liquid solvents, carbon dioxide is highly compressible and the density (and therefore solvent properties) can be tuned over a wide range by varying the pressure [see M. McHugh *et al*. "Supercritical Fluid Extraction" Boston, Butterworth-Heinemann, 1994]. Compressed carbon dioxide is a superior solvent medium for heavily fluorinated compounds. Compressed carbon dioxide has also been used as a (co-)solvent in the preparation of finely feathered sprays to coat surfaces with polymers [D. C. Busby, *et al., Surf Coat. Int*. 1991 **74**, 362; J. M. DeSimone, *et al., J. Supercrit. Fluids* 1999, **15**, 173]. These prior art feathered sprays have been used to coat the surfaces of stone in the walls of historical buildings and the like with a protective layer of fluropolymer.

The use of supercritical fluids for the production of particles has increased enormously within the past few years due to their readily adjustable densities and particularly their pressure-dependent solvent power. In the RESS-process (rapid expansion of supercritical solutions) the expansion of a supercritical solution leads to a decrease in solvent power and hence to the precipitation of the organic or inorganic solute [J. W. Tom and P. G. Debenedetti, *J. Aerosol Sci.,* 1991, **22**, 555]. As the decompression is fast, high supersaturation is reached and fine powders can be obtained. The most common solvent in this process is carbon dioxide because of its mild critical temperature (31°C) and its relatively low critical pressure (73 bar). As a result of the mild temperature, the RESS-process offers the opportunity to micronise heat-sensitive organics. These are otherwise difficult to comminute as they are thermally degraded. Another advantage of carbon dioxide is that it is a gas under atmospheric conditions so that the end-reaction mixture is solvent-free.

The morphology of the precipitated product is strongly influenced by the conditions of the expansion process. This is due to variations in nozzle design, solution concentration and parameters such as pressure and temperature [F. E. Hénon, M. Camaiti, A. L. C. Burke, R. G. Carbonell, J. M. DeSimone and F. Piacenti, *J. Supercrit. Fluid*., 1999, **15**, 1731.

In recent years, there has been considerable interest in light emitting organic materials such as conjugated polymers. Light emitting polymers possess a delocalised pi-electron system along the polymer backbone. The delocalised pi-electron system confers semiconducting properties to the polymer and gives it the ability to support positive and negative charge carriers with high mobilities along the polymer chain. Thin films of these conjugated polymers can be used in the preparation of optical devices such as light-emitting devices. These devices have numerous advantages over devices prepared using conventional semiconducting materials, including the possibility of wide area displays, low dc working voltages and simplicity of manufacture. Devices of this type are described in, for example, WO-A-90/13148, US 5,512,654. and WO-A-95/06400.

The world market for displays based on organic and polymeric light-emitting materials has recently been estimated by Stanford Resources, Inc., to be $ 200 million in the year 2002 with a strong growth rate which fuels the high industrial interest in this area (D.E. Mentley, "Flat Information Displays: Market and Technology Trends", 9^{th} edition, 1998). Efficient and highly stable LED devices with low power consumption, which fulfill commercial requirements, have been prepared by a number of companies and academic research groups (see, for example, R.H. Friend et al., *Nature* 1999, *397*, 12).

At the moment, great efforts are dedicated to the realization of a full-colour, all plastic screen. The major challenges to achieve this goal are: (1) access to conjugated polymers emitting light of the three basic colours red, green and blue; (2) the conjugated polymers must be easy to process and fabricate into full-colour display structures. Organic electroluminescent devices such as polymeric LEDs (PLEDs) show great promise in meeting the first requirement, since manipulation of the emission colour can be achieved by changing the chemical structure of the organic emissive compound. However, while modulation of the chemical nature of the emissive layer is often easy and inexpensive on the lab scale it can be an expensive and complicated process on the industrial scale.

The second requirement of the easy processability and build-up of full-colour matrix devices raises the question of how to micro-pattern fine multicolour pixels and how to achieve full-colour emission. Inkjet printing and hybrid inkjet printing technology have recently attracted much interest for the patterning of organic LED devices (see, for example, R.F. Service, *Science* 1998, *279*, 1135; Wudl et al., *Appl. Phys. Lett*. 1998, *73*, 2561; J. Bharathan, Y. Yang, *Appl. Phys. Lett*. 1998, *72*, 2660; and T.R. Hebner, C.C. Wu, D. Marcy, M.L. Lu, J. Sturm, *Appl. Phys. Lett*. 1998, *72*, 519). Many problems exist in adapting this technology for the patterning of organic LED devices, not least being that of finding suitable solvents for the polymers and small organic molecules to enable them to be sprayed in a controlled manner onto the surface of the devices. It would be highly desirable to find a solvent which can be used for many of the typical small organic molecules and polymers used in organic LED devices which enables precise patterning of the devices with small droplets of the polymer solution or small organic molecule solution, and which is inexpensive, non-toxic, non-flammable, dissolves the polymers at mild temperatures and is a gas under atmospheric conditions.

Organic field-effect transistors (FETs) have recently become of interest for applications in cheap, logic circuits integrated on plastic substrates [C. Drury, et al., APL 73, 108 (1998)] and optoelectronic integrated devices and pixel transistor switches in high-resolution active-matrix displays [H. Sirringhaus, et al., Science 280, 1741 (1998), A. Dodabalapur, et al. Appl. Phys.Lett. 73, 142 (1998)]. In these FETs, the semiconducting layer comprises an organic semiconducting material. These organic semiconductors include both polymers and small organic molecules. Examples of suitable polymers include (optionally substituted) polythiophenes such as polythiophene and poly(3-alkylthiophenes) [Horowitz, Advanced Materials, 10, 365, (1998)]; and copolymers which incorporate thiophene and fluorene units such as poly-9,9' dioctyl-fluorene-co-bithiophene (F8T2) [H. Sirringhaus, et al., Applied Physics Letters, 77, 406 (2000)]. Examples of suitable small organic molecules include oligothiophenes (typically containing 3 to 6 thiophene units), pentacenes and phthalocyanines.

In test device configurations with a polymer semiconductor and inorganic metal electrodes and gate dielectric layers high-performance FETs have been demonstrated. Charge carrier mobilities up to 0. 1 cm²/Vs and ON-OFF current ratios of 10⁶~10⁸ have been reached which is comparable to the performance of amorphous silicon FETs [H. Sirringhaus, et al., Advances in Solid State Physics 39, 101 (1999)].

Typical architecture of polymer FETs is shown in Horowitz, Advanced Materials, 10, 365, (1998).

Thin, device-quality films of conjugated polymer semiconductors can be formed by coating a solution of the polymer in an organic solvent onto the substrate. The technology is therefore ideally suited for cheap, large-area solution processing compatible with flexible, plastic substrates. In particular, it enables processing using high-resolution inkjet printing techniques to produce thin-film transistor circuits (Physics Today, February 2001). However, as for the organic LEDs, various problems exist with the adoption of inkjet technology, including the choice of solvent.

Other applications in which the precise patterning of polymers, small organic molecules and organic and inorganic particles onto surfaces is required include the patterning of DNA and protein molecules in arrays (e.g. in DNA chips, probes and biosensors) and in catalyst arrays.

### Summary of the invention

It is an object of the present invention to provide a method for the patterned deposition of materials onto surfaces in a controlled manner using a cheap, environmentally friendly solvent as defined in appended claim 1.

Various types of devices incorporating patterned materials deposited may be provided using the method of the present invention.

Thus, according the present invention, there is provided a method for the patterned deposition of a material comprising the steps of:
(i) dissolving or suspending said material in a solvent phase comprising compressed carbon dioxide; and
(ii) depositing the solution or suspension onto a surface, evaporation of the solvent phase leaving a patterned deposit of said material, the diameter of each deposited spot of material being from 1-100 µm and the space between each deposited spot of material being from 10-30 µm.

By compressed carbon dioxide, we mean carbon dioxide which has been compressed under pressure to produce liquid carbon dioxide or supercritical carbon dioxide. Compressed carbon dioxide has excellent properties that enables it to dissolve or have suspended therein a wide range of materials such as small organic molecules, polymers and inorganic or organic particles, these solutions and suspensions being ideal for the patterned deposition of the dissolved or suspended materials.

By patterned deposition we mean any means of creating a pattern on a surface including the directing of sprays or droplets of the material dissolved or suspended in compressed carbon dioxide directly onto a surface so as to create the pattern directly on said surface or by the directing of sprays or droplets of the material dissolved or suspended in compressed carbon dioxide onto patterned surfaces created by chemical and physical modification including surfaces modified by a lithographic technique or a printing technique.

Small organic molecules, polymers and inorganic or organic particles (ranging, for example, in size from 1 nm to 1 µm) can be deposited from compressed carbon dioxide.

Preferably, deposition of the material from carbon dioxide onto the surface involves the user of a device designed for the purpose, said device usually incorporating a capillary tube or nozzle from which the material is deposited. One preferred means of deposition employs a spray coating device to deliver feathered sprays of solutions or suspensions of the materials mentioned above. Another, most preferred option for deposition employs a modified version of an inkjet printer (e.g. such as the modified inkjet printers disclosed in R.F. Service, *Science* 1998, *279,* 1135; Wudl et al., *Appl. Phys. Lett*. 1998, *73*, 2561; J. Bharathan, Y. Yang, *Appl. Phys. Lett*. 1998, *72*, 2660; T.R. Hebner, C.C. Wu, D. Marcy, M.L. Lu, J. Sturm, *Appl. Phys. Lett*. 1998, *72*, 519; WO-A-01/16251; and Physics Today, February 2001, the contents of said publications being incorporated herein by reference thereto).

Thus, in a preferred embodiment of the present invention, there is provided a method for the patterned deposition of a material comprising supplying a solution processible formulation via a plurality of elongate bores onto a surface, wherein said formulation comprises said material dissolved or suspended in a solvent phase comprising compressed carbon dioxide.

Examples of particularly preferred embodiments of the material to be dissolved or suspended in the compressed carbon dioxide include organic light emitting materials such as a light emitting small organic molecules and light emitting conjugated polymers and organic semiconducting materials such as semiconducting small organic molecules and semiconducting polymers.

Small amounts of co-solvents such as water, trifluoroethanol, acetone, ethanol or methanol may be added to aid in the formation of a homogeneous solution or suspension, as well as in the formation of a fine spray. Furthermore, in some instances small amounts of surfactants such as perfluorinated polyethers (e.g. Fomblin®) can be added to aid the formation of a homogeneous solution or suspension.

The morphology of the precipitated material is strongly influenced by the conditions of the expansion process. This can be affected by variations in nozzle design, solution concentration and parameters such as pressure and temperature.

In the modified inkjet process, droplets of the solution are deposited via a plurality of elongate tubes. The tubes are very narrow in diameter, typically having an internal diameter in the region of 20 to 200 µm. The formation of the droplet can be influenced by optimising the residence time between the gas and the liquid phases and the ratio of the length to the diameter of the tubes.

Compressed carbon dioxide is an attractive solvent for the patterned deposition of materials because it is inexpensive, non-toxic, and non-flammable. The use of carbon dioxide as a solvent for patterned deposition is of major environmental as well as economic importance. The use of carbon dioxide in controlled deposition onto surfaces has clear applications in many techniques which involve the patterned deposition of polymers, small organic molecules and the like, such applications including desktop publishing and fabrication of optical and electronic devices.

One particularly preferred application of this technique for the patterned deposition of materials is in the deposition of organic and polymeric materials for optoelectronic devices including organic and polymer LEDs and transistors and associated circuitry.

One of the current issues in passive matrix driven display devices is to address individual columns and rows with the avoidance of crosstalk. Alternatively these issues can be resolved by the use of thin film transistors to provide active matrix addressing. These issues have been fully discussed in articles by J. H. Burroughes, D. D. C. Bradley, A. R Brown, R N. Marks, K. MacKay, R H. Friend, P. L. Burn and A. B. Holmes, *Nature,* 1990, **347**, 539; A. Kraft, A. C. Grimsdale and A. B. Holmes, *Angew. Chem. Int. Ed. Engl*., 1998, **37**, 402; , R. H. Friend, R W. Gymer, A. B. Holmes, J. H. Burroughes, R.N. Marks, C. Taliani, D.D.C. Bradley, D.A. dos Santos, J.L. Brédas, M. Lögdlund and W. R. Salaneck, *Nature,* 1999,**397**,121; H. Sirringhaus, T. Kawase, R. H. Friend, T. Shimoda, M. Inbasekaran, W. Wu, and E. P. Woo, *Science,* 2000, **290**, 2123.

The unique properties of compressed carbon dioxide should provide particular advantages in its use as a solvent in the deposition of organic and polymer layers in organic and polymer LEDs and transistors in terms of the resolution of the patterns produced and in the controlled evaporation of the processing solvent to afford high quality thin films.
Of the materials currently used for the organic light emitting layer in organic LEDs, many of the small organic molecules such as aluminium quinolinol complexes (Alq₃ complexes: see, for example US-A-4,539,507), complexes of transition metals, lanthanides and actinides with organic ligands such as TMHD (see WO-A-00/26323) and quinacridone, rubrene and styryl dyes (see, for example, JP-A-264692/1988), the contents of which references are incorporated herein by reference thereto, should be easily soluble in compressed carbon dioxide. This makes them particularly suitable for adoption in the patterned deposition method of the present invention, thus enabling the simple, cheap and controlled patterning of films of these compounds in the construction of organic LEDs. On the other hand, most of the polymers currently used in organic LEDs such as polyphenylene-vinylene (PPV) and derivatives thereof (see, for example, WO-A-90/13148), polyfluorene derivatives (see, for example, A. W. Grice, D. D. C. Bradley, M. T. Bernius, M. Inbasekaran, W. W. Wu, and E. P. Woo, *Appl. Phys. Lett*. 1998, 73, 629, WO-A-00/55927 and Bemius et al., *Adv. Materials,* 2000, 12, No. 23, 1737), polynaphthylene derivatives, polyindenofluorene derivatives and polyphenanthrenyl derivatives, the contents of which references are incorporated herein by reference thereto, are insoluble in compressed carbon dioxide. However, these polymers are easily derivatised and it should be relatively easy to introduce groups into these polymers which increase their solubility in compressed carbon dioxide, thus making them amenable to the method of patterned deposition of the present invention. (e.g. see "Polymer synthesis and processing using supercritical carbon dioxide" by A. I. Cooper, *J. Mater. Chem*., 2000, **10**, 207-234. Typical features which endow solubility to polymers in compressed carbon dioxide include the presence of perfluorinated or partially fluorinated alkyl ansd aryl substituents, polysiloxanes and specialist features such as those present in the polyether/polycarbonate described by T. Sarbu, T. Styranec and E. Beckman, *Nature*, 2000, **405**, 165).

At their most basic, organic electroluminescent devices generally comprise an organic light emitting material which is positioned between a hole injecting electrode and an electron injecting electrode. The hole injecting electrode (anode) is typically a transparent tin-doped indium oxide (ITO)-coated glass substrate. Zirconium-doped indium oxide (Applied Physics Letters, 78 (8) 1050 (2001), Kim, H et al) and aluminium-doped zinc oxide (Applied Physics Letters, 76 (3) 259 (2000), Kim H et al) films have also been used as the anode. The material commonly used for the electron injecting electrode (cathode) is a low work function metal such as calcium or aluminium.

The choice of anode material for organic electroluminescent devices is based on several criteria: the anode must have good optical transparency, good electrical conductivity, good chemical stability and, preferably, a work function that lies near the HOMO levels of the organic materials to which it will inject holes. Doped indium oxide largely meets these criteria. Alternatives as the anode material that have also been tried include: titanium nitride [Advanced Materials, 11 (9) 727 (1999), Adamovich V, et al.]; high work function transparent conducting oxides including Ga-In-Sn-O and Zn-In-Sn-O [Advanced Materials, 13 (19) 1476 (2001), Cui, J., et al]; polymeric materials such as polystyrenesulfonic acid-doped polyaniline [Applied Physics Letters, 70 (16) 2067 (1997); Carter S.A et al, and Applied Physics Letters, 64 (10) 1245 (1994) Yang Y et al.].

The organic light emitting layer can comprise mixtures or discrete layers of two or more different emissive organic materials.

Typical device architecture is disclosed in, for example, WO-A-90/13148; US-A-5,512,654; WO-A-95/06400; R.F. Service, *Science* 1998, *279*, 1135; Wudl et al., *Appl. Phys. Lett*. 1998, *73,* 2561; J. Bharathan, Y. Yang, *Appl. Phys. Lett.* 1998, *72*, 2660; T.R. Hebner, C.C. Wu, D. Marcy, M.L. Lu, J. Sturm, *Appl. Phys. Lett*. 1998, *72*, 519); and WO 99/48160; the contents of which references are incorporated herein by reference thereto.

The injection of holes from the hole injecting layer such as ITO into the organic emissive layer is controlled by the energy difference between the hole injecting layer work function and the highest occupied molecular orbital (HOMO) of the emissive material, and the chemical interaction at the interface between the hole injecting layer and the emissive layer. The deposition of high work function organic materials on the hole injecting layer, such as poly(styrene sulfonate)-doped poly (3,4-ethylene dioxythiophene) (PEDOT/PSS), N,N'-diphenyl-N,N'-(2-naphthyl)-(1,1'-phenyl)-4,4'-diamine (NBP) and N,N'-bis(3-methylphenyl)-1,1'-biphenyl-4,4'-diamine (TPD); provides "hole transport" layers which facilitate the hole injection into the light emitting layer, transport holes stably from the hole injecting electrode and obstruct electrons. These layers are effective in increasing the number of holes introduced into the light emitting layer.

In a further embodiment of the present invention there is provided a method for the manufacture of an organic light emitting diode comprising dissolving or suspending an emissive small organic molecule or an emissive conjugated polymer in a solvent phase comprising compressed carbon dioxide, and then depositing the solution or suspension onto the desired layer of said light emitting diode, evaporation of the solvent phase leaving a patterned light emitting layer comprising the deposited emissive small organic molecule or emissive conjugated polymer. In a particularly preferred embodiment, the solution or suspension of the emissive small organic molecule or emissive conjugated polymer is deposited via a plurality of elongate bores. The present invention also provides an organic light emitting diode manufactured according to this method.

Another appplication of the method of the present invention is the patterned deposition of the organic semiconducting layers in organic transistors. These organic semiconductors include both polymers and small organic molecules. The small organic molecules currently used, which include oligothiophenes (typically containing 3 to 6 thiophene units), pentacenes and phthalocyanines; should be soluble in compressed carbon dioxide, making them particularly suitable for adoption in the patterned deposition method of the present invention, thus enabling the simple, cheap and controlled patterning of films of these compounds in the construction of polymeric transistors. Again, however, most of the polymers currently used [e.g. (optionally substituted) polythiophenes such as polythiophene and poly(3-alkylthiophenes) [Horowitz, Advanced Materials, 10, 365, (1998)]; and copolymers which incorporate thiophene and fluorene units such as poly-9,9' dioctyl-fluorene-co-bithiophene (F8T2) [H. Sirringhaus, et al., Applied Physics Letters, 77, 406 (2000)], the contents of which are incorporated herein by reference thereto] are insoluble in compressed carbon dioxide. However, these polymers are also easily derivatised so that it should be relatively easy to introduce moieties which will enable their solubilisation in compressed carbon dioxide (e.g. as for the emissive organic polymers above).

Typical architecture of polymer transistors is shown in Horowitz, Advanced Materials, 10, 365, (1998), the contents of which are incorporated herein by reference thereto.

The method of the present invention is suitable for the manufacture of an organic transistor comprising dissolving or suspending a semiconducting small organic molecule or a semiconducting conjugated polymer in a solvent phase comprising compressed carbon dioxide, and then depositing the solution or suspension onto the desired layer of said organic transistor, evaporation of the solvent phase leaving a patterned semiconducting layer comprising the deposited semiconducting small organic molecule or semiconducting conjugated polymer. In a particularly preferred embodiment, the solution or suspension of the semiconducting small organic molecule or semiconducting conjugated polymer is deposited via a plurality of elongate bores. The present invention also provides an organic transistor manufactured according to this method.

The method of the present invention for the use of compressed carbon dioxide in the patterned deposition of materials also has other applications such as the deposition into array format of catalysts, DNA, or proteins or materials for sensors. The method of the present invention can also be used in the manufacture of organic solid state photovoltaic devices in which the microphase separation of materials of different charge density, which could be deposited by the method of the invention, determines the ability to promote charge separation (see, for example; Halls et al, Nature, 1995, 376, 498).

In one example, we have found that a perfluorinated polymer [poly(methyl methacrylate) carrying a perfluorinated alkyl side chain] can be dissolved in liquid carbon dioxide. The polymer solution was deposited by use of a nozzle onto a pre-pattemed surface. The resulting polymer film showed a clear image of the original pattern as measured by optical microscopy.

The straightforward integration of multiple organic layers (for the fabrication of red, green, and blue emitters for colour displays) would require the patterning of the individual organic layers. Because of their lack of solubility in and sensitivity to aqueous solutions and many solvents, the patterning of such organic materials by conventional photoresist and wet processing techniques is difficult. Effort to date to integrate organic light emitting diodes (OLEDs) which emit different colours on the same substrate have patterned them only indirectly (through the use of cathodes evaporated through shadow mask as dry-etch masks), or avoided the issue all together by putting the three devices on top of each other (relying on shadow masks to pattern the organics so that contacts to the multiple layers may be made). Since some of the conducting (or conjugated) polymers and many of the small organic polymers are solution processable, inkjet printing technology is an ideal method for printing polymer and small organic light-emitting diodes with high resolution. The use of compressed carbon dioxide, with all the advantages described above, provides a particularly favourable technique for high resolution patterning of the organic films.

### Brief description of the drawings

The present invention may be further understood by consideration of the following embodiments of the present invention, with reference to the following drawings in which:
Figure 1 shows a schematic diagram of a method for spraying or dropping a polymer onto a silicon substrate;
Figures 2 and 3 are photographs showing the effect of spraying compressed carbon dioxide solutions of a fluorinated polymer on pre-pattemed silicon substrates;
Figure 4 is a photograph showing the effect of spraying compressed carbon dioxide solutions of a fluorinated polymer via a capillary tube on pre-patterned silicon substrates; and
Figure 5 is a photograph of one of the pre-pattemed substrates.

### Description of Preferred Embodiments

### Example 1: Fine Sprays

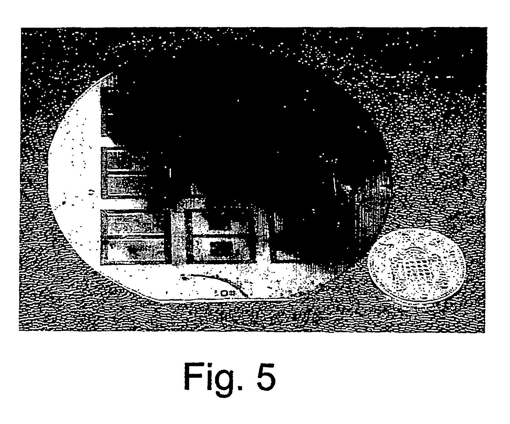

2 mg of either poly(perfluorooctyl methacrylate) (PFOMA) or poly(perfluoro-octyl acrylate) (PFOA) were placed inside a stainless steel vessel suitable for storing compressed carbon dioxide and adjusting the temperature and pressure thereof, such as that described, for example, by Hems, *et al*. (*J. Mater. Chem*., 1999, **9**, 1403). The vessel was initially filled with liquid CO₂ at a temperature of 20°C and a pressure of 103 bar (1500 psi). The polymer dissolved in the liquid CO₂ to form a colourless solution. In further experiments, 0.05 ml of water and methanol respectively were included as co-solvents and the perfluorinated polyether Fomblin® (0.05 ml) was included as a surfactant. The cell was then vented via a narrow metal tube to give a feathered spray of the polymer solution while holding a patterned silicon wafer approximately 10 cm away from the nozzle. The wafer (supplied by Mr Masaya Ishida of Seiko Epson) was patterned by lithography to give hydrophilic and hydrophobic areas, the PFOA and PFOMA sticking to the hydrophilic areas to give the pattern. A photograph of such a wafer is shown in Figure 5. The wafer was then studied under the microscope and revealed an identical polymer pattern to that on the original surface of the wafer, thus proving the excellent potential that compressed carbon dioxide has as a solvent for use in the deposition of polymeric materials via fine sprays.

| **Results of spraying experiments with CO**_{**2**} | | | |
|---|---|---|---|
| **Polymer** | **Cosolvent** | **Solubility** | **Results** |
| PFOMA^{a} | | CO₂ | Yes |
| PFOA^{b} | Water + Fomblin^{c} | CO₂ | Yes |
| PFOMA^{a} | Methanol + Fomblin | CO₂ | Yes |

| | | | |
|---|---|---|---|
| ^{a} Synthesised by anionic polymerisation. | | | |
| ^{b}PFOA = poly(perfluoro-octyl acrylate) | | | |
| ^{c}Trade mark of Ausimont. | | | |

### Example 2: Deposition by Spraying via a Modified Micrometering Valve

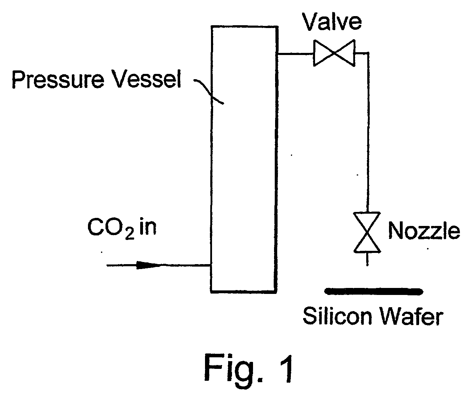

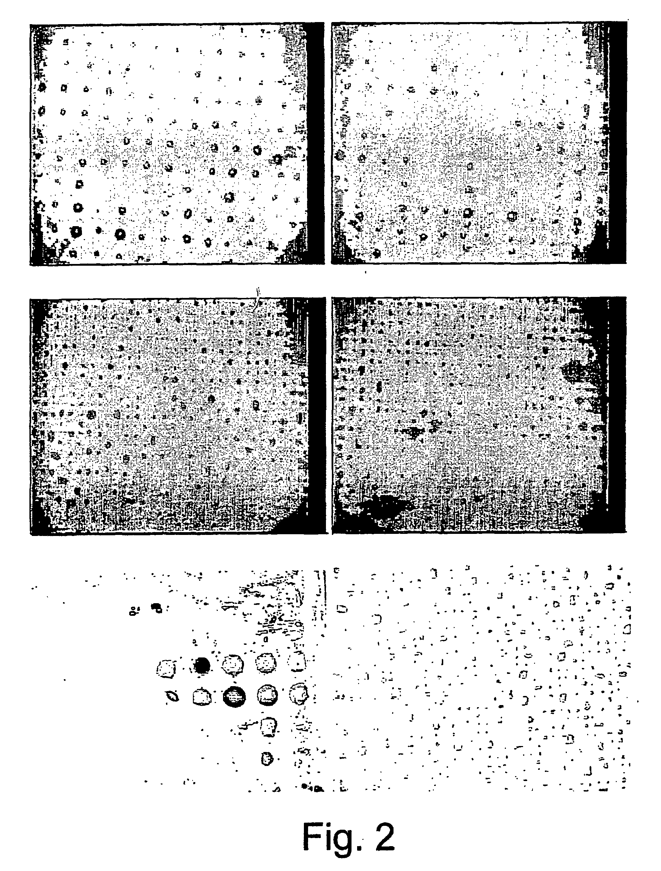

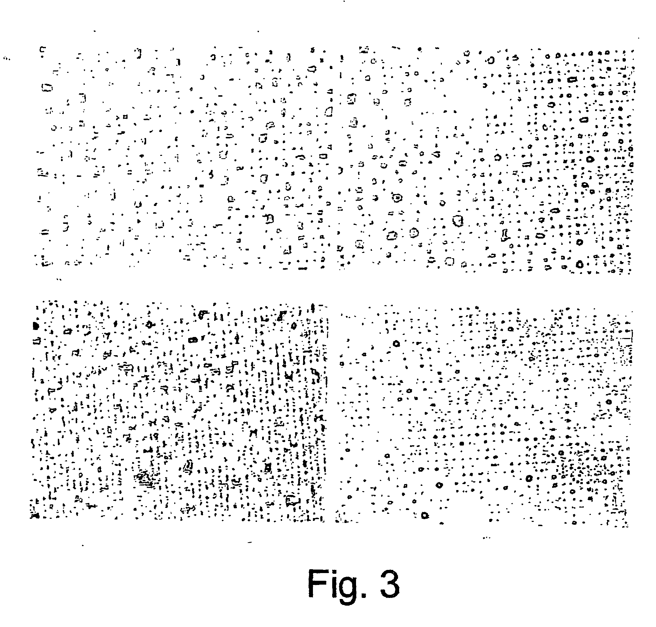

0.5 g of Fluorolink® (a perfluorinated polyether manufacture by Ausimont) were placed inside a stainless steel pressure vessel suitable for storing compressed carbon dioxide and adjusting the temperature and pressure thereof, such as that described, for example, by Hems, *et al*. (*J. Mater. Chem.,* 1999, **9**, 1403). A schematic representation of the vessel is shown in Figure 1. The vessel was initially filled with liquid CO₂ and the temperature adjusted to room temperature and the pressure to 100 bar. The polymer dissolved in the liquid CO₂ to form a colourless solution. The cell was then vented via a nozzle which was a modified micrometering valve to give a feathered spray of the polymer solution while holding a patterned silicon wafer approximately 10 cm away from the nozzle. The flow-rate of the solution was between 1 and 5 kg h⁻¹ and the residence time of the wafers in the spraying stream was between 30 and 60 seconds. The wafer (supplied by Mr Masaya Ishida of Seiko Epson) was patterned by lithography to give hydrophilic and hydrophobic areas, the polymer sticking to the hydrophobic areas. The wafer was then studied under the microscope. Photographs of the patterns obtained are shown in Figures 2 and 3. The photographs show an identical polymer pattern to that on the original surface of the wafer.

### Example 3: Deposition by Spraying via Capillary Tubes

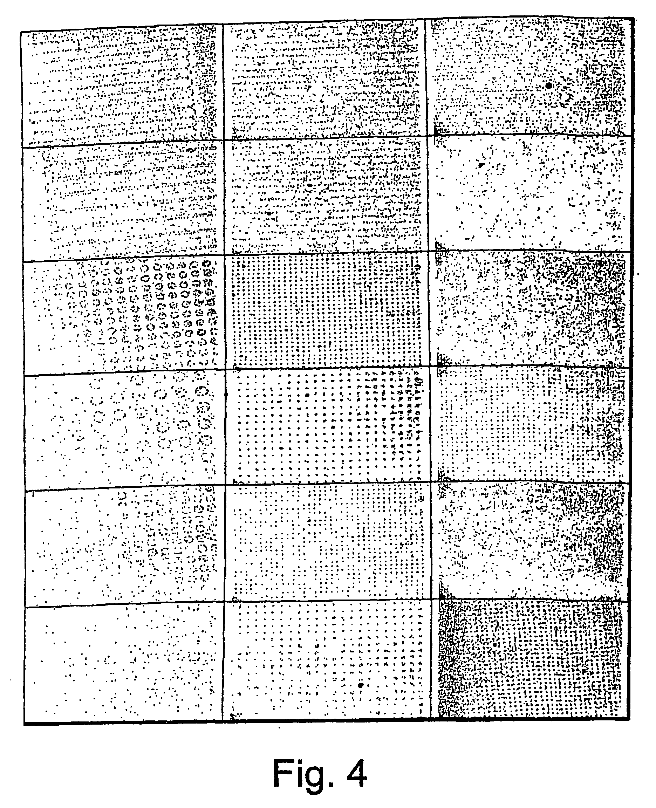

0.51 g of Fluorolink® (a perfluorinated polyether manufacture by Ausimont) were placed inside a stainless steel pressure vessel suitable for storing compressed carbon dioxide and adjusting the temperature and pressure thereof, such as that described, for example, by Hems, *et al.* (*J. Mater. Chem*., 1999, **9**, 1403). A schematic representation of the vessel is shown in Figure 1. The vessel was initially filled with supercritical CO₂ and the temperature adjusted to 35°C and the pressure to 100 bar. The polymer dissolved in the supercritical CO₂ to form a colourless solution. The cell was then vented of the polymer solution via a capillary tube having an internal diameter of 127 µm and a length of either 10 cm or 30 cm while holding a patterned silicon wafer 3 cm away (10 cm capillary tube) or 2 cm away (30 cm capillary tube) from the tube. The solution exited the tube as a spray with a flow-rate of the solution was between 1 and 5 kg h⁻¹. The wafer (supplied by Mr Masaya Ishida of Seiko Epson) was patterned by lithography to give hydrophilic and hydrophobic areas, the polymer sticking to the hydrophobic areas. The wafer was then studied under the microscope. Photographs of the patterns obtained with the 10 cm capillary tube are shown in Figure 4. The photographs show an identical polymer pattern to that on the original surface of the wafer. Similar results were obtained with the 30 cm capillary tube.

In Examples 1 to 3, the typical dot size of the deposited polymer was in the range 5 to 40 microns in diameter and the average space between the dots was 10 to 30 microns. This represents an excellent resolution level, showing the potential of the method of the present invention. Each of the squares in the photos is a single patterned area of the wafer and is 643 x 490 microns in size.

## Claims

1. A method for the patterned deposition of a material comprising the steps of:
(i) dissolving or suspending said material in a solvent phase comprising compressed carbon dioxide; and
(ii) depositing the solution or suspension onto a surface, evaporation of the solvent phase leaving a patterned deposit of spots of said material, the diameter of each deposited spot of material being from 1 to 100 µm and the space between each deposited spot of material being from 10 to 30 µm.

2. A method according to claim 1 wherein the solution or suspension of the material in the solvent phase comprising compressed carbon dioxide is deposited by means of a spray coating device.

3. A method according to claim 1 wherein the solution or suspension of the material in the solvent phase comprising compressed carbon dioxide is deposited by means of a modified inkjet printing device.

4. A method according to claim 1, wherein the material dissolved or suspended in the solvent phase comprising compressed carbon dioxide is deposited onto said surface via a plurality of elongate bores.

5. A method according to claim 4, wherein the bores have an internal diameter of from 20 to 200 µm.

6. A method according to any one of claims 1 to 5, wherein a co-solvent is added to the compressed carbon dioxide.

7. A method according to claim 6, wherein said co-solvent is selected from the group consisting of water, trifluoroethanol, acetone, ethanol and methanol.

8. A method according to any one of claims 1 to 7, wherein a surfactant is added to the compressed carbon dioxide.

9. A method according to any one of claims 1 to 8, wherein the material to be deposited is a polymer that is soluble in compressed carbon dioxide selected from the group consisting of perfluorinated polyethers, perfluorinated alkyl(meth)acrylates, silicone-containing polymers and polyethylene oxide (PEO) containing polymers.

10. A method according to any one of claims 1 to 8, wherein the material to be deposited is a small organic molecule that is soluble in compressed carbon dioxide.

11. A method according to any one of claims 1 to 8, wherein the material to be deposited is insoluble in compressed carbon dioxide and forms a suspension therein.

12. A method according to any one of claims 1 to 11, wherein the surface onto which the material is deposited has been pre-pattemed into areas that exhibit a different surface tension or chemical reactivity.

13. A method according to claim 12, where the surface is pre-pattemed into areas ranging in size between 0.1 µm to 10 mm.

14. A method according to any one of claims 1 to 11, wherein the surface is not pre-patterned, but a pattern arises after deposition of the material.

15. A method according to any one of claims 1 to 14 for the manufacture of an organic light emitting diode, comprising dissolving or suspending an emissive small organic molecule or an emissive conjugated polymer in a solvent phase comprising compressed carbon dioxide, and then depositing the solution or suspension onto the desired layer of said light emitting diode, evaporation of the solvent phase leaving a patterned light emitting layer comprising the deposited emissive small organic molecule or emissive conjugated polymer.

16. A method according to claim 15, wherein said solution or suspension of an emissive small organic molecule or an emissive conjugated polymer is deposited via a plurality of elongate bores.

17. A method according to any one of claims 1 to 14 for the manufacture of an organic transistor, comprising dissolving or suspending a semiconducting small organic molecule or a semiconducting conjugated polymer in a solvent phase comprising compressed carbon dioxide, and then depositing the solution or suspension onto the desired layer of said organic transistor, evaporation of the solvent phase leaving a patterned semiconducting layer comprising the deposited semiconducting small organic molecule or semiconducting conjugated polymer.

18. A method according to claim 17, wherein the solution or suspension of the semiconducting small organic molecule or semiconducting conjugated polymer is deposited via a plurality of elongate bores.

19. A method according to any one of claims 1 to 14 for the deposition into array format on a surface of a substance selected from DNA, proteins, catalysts and materials for sensors, comprising dissolving or suspending said substance in a solvent phase comprising compressed carbon dioxide, and then depositing the solution or suspension onto said surface, evaporation of the solvent phase leaving the desired array of said substance.

20. A surface having thereon a patterned deposit of a material obtainable according to the method of claim 1, wherein said solution or suspension of a material is deposited via a plurality of elongate bores.

21. An organic light emitting diode obtainable according to the method of claim 15, wherein said solution or suspension of an emissive small organic molecule or an emissive conjugated polymer is deposited via a plurality of elongate bores.

22. An organic transistor obtainable according to the method of claim 17, wherein the solution or suspension of the semiconducting small organic molecule or semiconducting conjugated polymer is deposited via a plurality of elongate bores.

23. An array of a substance selected from DNA, proteins, catalysts and materials for sensors obtainable according to the method of claim 19, wherein said solution or suspension of a substance selected from DNA, proteins, catalysts and materials for sensors is deposited via a plurality of elongate bores.

## Patentansprüche

1. Verfahren für die gerasterte Abscheidung eines Materials, umfassend die Schritte:
(i) Auflösen oder Suspendieren des Materials in einer Lösemittelphase, die unter Druck befindliches Kohlendioxid aufweist; und
(ii) Abscheiden der Lösung oder Suspension auf einer Oberfläche, Abdampfen der Lösemittelphase, die eine gerasterte Abscheidung von Materialpünktchen aus dem Material zurücklässt, wobei der Durchmesser jedes abgeschiedenen Materialpünktchens des Materials 1 bis 100 µm beträgt und der Abstand zwischen jedem abgeschiedenen Materialpünktchen 10 bis 30 µm beträgt.

2. Verfahren nach Anspruch 1, bei welchem die Lösung oder Suspension des Materials in der Lösemittelphase unter Druck befindliches Kohlendioxid aufweist und mit Hilfe einer Vorrichtung zum Spritzbeschichten abgeschieden wird.

3. Verfahren nach Anspruch 1, bei welchem die Lösung oder Suspension des Materials in der Lösemittelphase unter Druck befindliches Kohlendioxid aufweist und mit Hilfe einer modifizierten Vorrichtung zum Tintenstrahldrucken abgeschieden wird.

4. Verfahren nach Anspruch 1, bei welchem das in der Lösemittelphase aufgelöste oder suspendierte Material unter Druck befindliches Kohlendioxid aufweist und auf der Oberfläche über eine Mehrzahl langgestreckter Bohrungen abgeschieden wird.

5. Vetfahien nach Anspruch 4, bei welchem die Bohrungen einen Innendurchmesser von 20 bis 200 µm haben.

6. Verfahren nach einem der Ansprüche 1 bis 5, bei welchem dem unter Druck befindlichen Kohlendioxid ein Hilfslösemittel zugesetzt ist.

7. Verfahren nach Anspruch 6, bei welchem das Hilfslösemittel ausgewählt ist aus der Gruppe, bestehend aus Wasser, Trifluorethanol, Aceton, Ethanol und Methanol.

8. Verfahren nach einem der Ansprüche 1 bis 7, bei welchem dem unter Druck befindlichen Kohlendioxid ein Tensid zugesetzt ist.

9. Verfahren nach einem der Ansprüche 1 bis 8, bei welchem das abzuscheidende Material ein Polymer ist, das in unter Druck befindlichem Kohlendioxid löslich ist, ausgewählt aus der Gruppe, bestehend aus perfluorierten Polyethern, perfluorierten Alkyl(meth)acrylaten, Silicium enthaltenden Polymeren und Polyethylenoxid(PEO)-enthaltenden Polymeren.

10. Verfahren nach einem der Ansprüche 1 bis 8, bei welchem das abzuscheidende Material ein kleines orgenisches Molekül ist, das in unter Druck befindlichem Kohlendioxid löslich ist.

11. Verfahren nach einem der Ansprüche 1 bis 8, bei welchem das abzuscheidende Material in unter Druck befindlichem Kohlendioxid unlöslich ist und darin eine Suspension erzeugt.

12. Verfahren nach einem der Ansprüche 1 bis 11, bei welchem die Oberfläche, auf die das Material abgeschieden ist, in Bereiche vorgerastert worden ist, die eine unterschiedliche Oberflächenspannung oder unterschiedliches chemisches Reaktionsvermögen zeigen.

13. Verfahren nach Anspruch 12, bei welchem die Oberfläobe in Bereiche vorgeisstert ist, deren Größe im Bereich von 0,1 µm bis 10 mm liegt.

14. Verfahren nach einem der Ansprüche 1 bis 11, bei welchem die Oberfläche nicht vorgerastert wurde, nach der Abscheidung des Materials jedoch ein Muster hervoriaonamt.

15. Verfahren nach einem der Ansprüche 1 bis 14 zur Herstellung einer organischen, lichtemittierenden Diode, umfassend das Auflösen oder Suspendieren eines zur Emission fähigen kleinen organischen Moleküls oder eines zur Emission fähigen konjugierten Polymere in einer Lösemittelphase, die unter Druck befindliches Kohlendioxid aufweist; und anschließend Abscheiden der Lösung oder Suspension auf der gewünschten Schicht der lichtemittierenden Diode, Abdampfen der Lösemittelphase, die eine gerasterte, lichtemittierende Schicht zurücklässt, die das abgeschiedene, zur Emission fähige kleine organische Molekül oder zur Emission fähige konjugierte Polymer aufweist.

16. Verfahren nach Anspruch 15, bei welchem die Lösung oder Suspension eines zur Emission fähigen, kleinen organischen Moleküls oder eines zur Emission fähigen konjugierten Polymers über eine Mehrzahl von langgestreckten Bohrungen abgeschieden wird.

17. Verfahren nach einem der Ansprüche 1 bis 14 für die Herstellung eines organischen Transistors, umfassend das Auflösen oder Suspendieren eines halbleitenden, kleinen organischen Moleküls oder eines halbleitenden konjugierten Polymers in einer Lösemittelphase, die unter Druck befindliches Kohlendioxid ausweist; und anschließend Abscheiden der Lösung oder Suspension auf der gewünschten Schicht des organischen Transistors; Abdampfen der Lösemittelphase, die eine gerasterte halbleitende Schicht zurücklässt, die das abgeschiedene, halbleitende kleine organische Molekül oder halbleitende konjugierte Polymer aufweist.

18. Verfahren nach Anspruch 17, bei welchem die Lösung oder Suspension des halbleitenden, kleinen organischen Moleküls oder halbleitenden kontugietten Polymers über eine Mehrzahl von langgestreckten Bohrungen abgeschieden wird.

19. Verfahren nach einem der vorgenannton Ansprüche 1 bis 14 für die Abscheidung einer Substanz zu einem Array-Format auf einer Oberfläche, die ausgewählt ist aus DNA, Proteinen, Katalysatoren und Materialien für Sensoren, umfassend das Auflösen oder Suspendieren der Substanz in einer Lösemittelphase, die unter Druck befindliches Kohlendioxid aufweist, und anschließend Abscheiden der Lösung oder Suspension auf dieser Oberfläche, Abdampfen der Lösemittelphase, die das gewünschte Array der Substanz zurücklässt.

20. Oberfläche, die darauf eine gerasterte Abscheidung eines Materials aufweist, die nach dem Verfahren nach Anspruch 1 erhalten werden kann, wobei die Lösung oder Suspension eines Materials über eine Mehrzahl langgestreckter Bohmngen abgeschieden wird.

21. Organische, lichtemittierende Diode, die nach dem Verfahren nach Anspruch 15 erhalten, werden kann, wobei die Lösung oder Suspension eines zur Emission fähigen kleinen organischen Moleküls oder eines zur Emission fähigen konjugierten. Polymers über eine Mehrzahl langgestreckter Bohrungen abgeschieden wird.

22. Organischer Transistor, der nach dem Verfahren nach Anspruch 17 erhalten werden kann, wobei die Lösung oder Suspension eines halbleitenden, kleinen organischen Moleküls oder eines halbleitenden konjugierten Polymers über eine Mehrzahl langgestreckter Bohrungen abgeschieden wird.

23. Array einer Substanz, ausgewählt aus DNA, Proteinen, Katalysatoren und Materialien für Sensoren, das nach dem Verfahren nach Anspruch 19 erhalten werden kann, wobei die Lösung oder Suspension einer Substanz, die ausgewählt ist aus DNA, Proteinen, Katalysatoren und Materialien für Sensoren, über eine Mehrzahl langgestreckter Bohrungen abgeschieden wird.

## Revendications

1. Procédé pour le dépôt à motifs d'un matériau comprenant les étapes:
(i) de dissolution ou de mise en suspension dudit matériau dans une phase de solvant comprenant du dioxyde de carbone comprimé; et
(ii) de dépôt de la solution ou de la suspension sur une surface, d'évaporation de la phase de solvant laissant un dépôt à motifs de points dudit matériau, le diamètre de chaque point déposé de matériau étant de 1 à 100 µm et l'espace entre chaque point déposé de matériau étant de 10 à 30 µm.

2. Procédé suivant la revendication 1, dans lequel la solution ou la suspension du matériau dans la phase de solvant comprenant du dioxyde de carbone comprimé est déposée au moyen d'un dispositif de revêtement par pulvérisation.

3. Procédé suivant la revendication 1, dans lequel la solution ou la suspension du metétiau dans la phase de solvant comprenant du dioxyde de carbone comprimé est déposée au moyen d'un dispositif d'impression à jet d'encre modifié.

4. Procédé suivant la revendication 1, dans lequel le matériau dissous ou en suspension dans la phase de solvant comprenant du dioxyde de carbone comprimé est déposé sur ladite surface via une pluralité de perçages allongés.

5. Procédé suivant la revendication 4, dans lequel les perçages possèdent un diamètre interne de 20 à 200 µm.

6. Procédé suivant l'une quelconque des revendications 1 à 5, dans lequel un co-solvant est ajouté au dioxyde de carbone comprimé.

7. Procédé suivant la revendication. 6, dans lequel ledit co-solvant est choisi dans le groupe constitué d'eau, de trifluoroéthanol, d'acétone, d'éthanol et de méthanol.

8. Procédé suivant l'une quelconque des revendications 1 à 7, dans lequel un tensioactif est ajouté au dioxyde de carbone comprimé.

9. Procédé suivant l'une quelconque des revendications 1 à 8, dans lequel le matériau à déposer est un polymère qui est soluble dans du dioxyde de carbone comprimé choisi dans le groupe constitué de polyéthers perfluorés, d'alkyl(méth)acrylates perfluorés, de polymères contenant de la silicone et de polymères contenant du poly(éthyléne oxyde) (PBO).

10. Procédé suivant l'une quelconque des revendications 1 à 8, dans lequel le matériau à déposer est une petite molécule organique qui est soluble dans du dioxyde de carbone comprimé.

11. Procédé suivant l'une quelconque des revendications 1 à 8, dans lequel le matériau à déposer est insoluble dans du dioxyde de carbone comprimé et forme une suspension dans celui-ci.

12. Procédé suivant l'une quelconque des revendications 1 à 11, dans lequel la surface sur laquelle le matériau est déposé a été mise en motifs au préalable dans des zones qui affichent une tension de surface ou une réactivité chimique différente.

13. Procédé suivant la revendication 12, dans lequel la surface est mise en motifs au préalable dans des zones variant en taille entre 0,1 µm et 10 mm.

14. Procédé suivant l'une quelconque des revendications 1 à 11, dans lequel la surface n'est pas mise en motifs au préalable, mais des motifs sont produits après le dépôt du matériau.

15. Procédé suivant l'une quelconque des revendications 1 à 14, pour la fabrication d'une diode électroluminescente organique, comprenant la dissolution ou la mise en suspension d'une petite molécule organique émissive ou d'un polymère conjugué émissif dans une phase de solvant comprenant du dioxyde de carbone comprimé, et ensuite le dépôt de la solution ou de la suspension sur la couche désirée de ladite diode électroluminescente, l'évaporation de la phase de solvant laissant une couche électroluminescente à motifs comprenant la petite molécule organique émissive ou le polymère conjugué émissif déposé.

16. Procédé suivant la revendication 15, dans lequel ladite solution ou suspension d'une petite molécule organique émissive ou d'un polymère conjugué émissif est déposée via une pluralité de perçages allongés.

17. Procédé suivant l'une quelconque des revendications 1 à 14, pour la fabrication d'un transistor organique, comprenant la dissolution ou la mise en suspension d'une petite molécule organique semi-conductrice ou d'un polymère conjugué semi-conducteur dans une phase de solvant comprenant du dioxyde de carbone comprimé, et ensuite le dépôt de la solution ou de la suspension sur la couche désirée dudit transistor organique, l'évaporation de la phase de solvant laissant une couche semi-conductrice à motifs comprenant la petite molécule organique semi-conductrice ou le polymère conjugué semi-conducteur déposé.

18. Procédé suivant la revendication 17, dans lequel la solution ou la suspension de la petite molécule organique semi-conductrice ou du polymère conjugué semi-conducteur est déposée via une pluralité de perçages allongés.

19. Procédé suivant l'une quelconque des revendications 1 à 14, pour le dépôt en un format en réseau sur une surface d'une substance choisie parmi un ADN, des protéines, des catalyseurs et des matériaux pour détecteurs, comprenant la dissolution ou la mise en suspension de ladite substance dans une phase de solvant comprenant du dioxyde de carbone comprimé, et ensuite le dépôt de la solution ou de la suspension sur ladite surface, l'évaporation de la phase de solvant laissant le réseau désire de ladite substance.

20. Surface présentant sur celle-ci un dépôt à motifs d'un matériau pouvant être obtenue selon le procédé suivant la revendication 1, dans laquelle ladite solution ou suspension d'un matériau est déposée via une pluralité de perçages allongés.

21. Diode électroluminescente organique pouvant être obtenue selon le procédé suivant la revendication 15, dans laquelle ladite solution ou suspension d'une petite molécule organique émissive ou d'un polymère conjugué émissif est déposée via une pluralité de perçages allongés.

22. Transistor organique pouvant être obtenu selon le procédé suivant la revendication 17, dans lequel la solution ou la suspension de la petite molécule organique semi-conductrice ou du polymère conjugué semi-conducteur est déposée via une pluralité de perçages allongés.

23. Réseau d'une substance choisie parmi un ADN, des protéines, des catalyseurs et des matériaux pour détecteurs pouvant être obtenu selon le procédé suivant la revendication 19, dans lequel ladite solution ou suspension d'une substance choisie parmi un ADN, des protéines, des catalyseurs et des matériaux pour détecteurs est déposée via une pluralité de perçages allongés.
